Europäisches Patentamt

European Patent Office

Office européen des brevets

(19)

(11) Veröffentlichungsnummer: **0 002 752**
**B1**

(12) **EUROPÄISCHE PATENTSCHRIFT**

(45) Veröffentlichungstag der Patentschrift: **16.09.81**

(21) Anmeldenummer: **78101718.1**

(22) Anmeldetag: **16.12.78**

(51) Int. Cl.³: **H 01 L 27/14,**
**H 01 L 31/10, H 01 L 31/02**

(54) Photodiodenanordnung.

(30) Priorität: **30.12.77 US 866128**

(43) Veröffentlichungstag der Anmeldung:
**11.07.79 Patentblatt 79/14**

(45) Bekanntmachung des Hinweises auf die Patenterteilung:
**16.09.81 Patentblatt 81/37**

(84) Benannte Vertragsstaaten:
**DE FR GB**

(56) Entgegenhaltungen:
**DE - A - 2 113 093**

(73) Patentinhaber: **International Business Machines Corporation**
**Armonk, N.Y. 10504 (US)**

(72) Erfinder: **Cade, Paul Edmand**
**RD 1 Severance Road**
**Colchester Vermont 05446 (US)**

(74) Vertreter: **Gaugel, Heinz, Dipl.-Ing.**
**Schönaicher Strasse 220**
**D-7030 Böblingen (DE)**

Photodiodenanordnung

Die Erfindung bezieht sich auf eine Photodiodenanordnung, bei welcher auf einem Halbleitersubstrat eines ersten Leitungstyps eine von einem Isolationsring desselben Leitungstyps umgebene Schicht eines zweiten Leitungstyps mit einem darunterliegenden, höher dotierten, als Subkollektor dienenden Bereich, und innerhalb dieser Schicht, angrenzend an die Oberfläche der Anordnung, eine dunne Oberflöchenschicht de ersten Leitungstyps gebildet sind und die an die Oberflächenschicht sowie die Schicht des zweiten Leitungstyps jeweils einen an der Oberfläche liegenden Kontaktanschluß aufweisen.

Photodioden dieser Art sind an sich bekannt, beispielsweise aus der US-A-3 529 217. Bei den in den US-Patentschriften 3 529 217, 3 812 518 und 3 836 793 beschriebenen Beispielen werden die sog. parasitären Ströme, die entlang dem in Sperrichtung vorgespannten pn-Übergang zwischen der Epitaxieschicht und dem Substrat entstehen, dadurch reduziert, daß eine sehr, sehr dicke, abschirmende Epitaxieschicht über einen sehr dicken Subkollektorbereich angeordnet wird und daß der Subkollektor so tief in das Substrat vergraben wird, daß er als Reflektor für die Minoritätsladungsträger wirkt.

In der US-Patentschrift 3 836 793 wird ferner eine Anordnung beschrieben, bei welcher die Epitaxieschicht mit einer Schicht aus undurchsichtigem Material abgedeckt wird, die sich mindestens um eine Diffusionslänge der Minoritätsladungsträger von den durch den Isolierring gebildeten Seitenwänden nach innen erstreckt, um die Diffusion der Minoritätsladungsträger zu diesen Wänden zu verhindern.

Diese bekannten Anordnungen enthalten die Lehre, daß wenn der vergrabene Subkollektor tiefer in das Substrat hinein verlagert wird, die Strahlung nicht bis zum Subkollektor/Substrat-Übergang durchdringt, daß Minoritätsladungsträger, die am strahlungsempfindlichen pn-Übergang erzeugt werden, nicht hinunter zum Subkollektor/Substrat-Übergang diffundieren, und daß Photonen, die in der unteren Hälfte des Bereichs des vergrabenen Subkollektors absorbiert werden, keinen Beitrag zum Photostrom liefern.

Die Erfindung, wie sie in den Ansprüchen gekennzeichnet ist, löst die Aufgabe, eine Photodiodenanordnung der oben genannten Art zu schaffen, bei welcher die Photonenabsorption im wesentlichen in einem derartigen Gebiet stattfindet, daß alle erzeugten Ladungsträger zum Photostrom beitragen können.

Zwar ist durch die DE-A-2 113 093 ein durch Photonen gesteuertes Halbleiterbauelement bekannt, bei welchem eine unterhalb der Oberfläche des Halbleitersubstrats angeordnete Zone mit gegenüber dem Substrat entgegengesetzter Leitungseigenschaft mit dem Substrat einen zusammenhängenden pn-Übergang

bildet. Bei diesem Bauelement handelt es sich jedoch im Gegensatz zu der Erfindung um einen mit einer Diode kombinierten Phototransistor, bei welchem de Photonen auf die Basis des Transistors einwirken und kein äußerer Anschluß der unterhalb der Oberfläche angeordneten Zone vorgesehen ist.

Die durch die Erfindung erzielten Vorteile sind im wesentlichen darin zu sehen, daß alle erzeugten Ladungsträger zum Photostrom beitragen und keine Leckströme entstehen, so daß die Diode einen höheren Wirkungsgrad besitzt, daß die Diode eine gegenüber dem Bekannten kürzere Ansprechzeit aufweist und daß die Isolationswände lediglich dazu notwendig sind, eine Verkoppelung von mehreren, auf einem Substrat angeordneten Dioden zu vermeiden, wodurch der Wirkungsgrad der Diode hinsichtlich der Geometrie verbessert wird.

Die Erfindung wird anhand eines durch die Zeichnungen erläuterten Ausführungsbeispieles beschrieben. Es zeigen:

Fig. 1 eine Photodiodenanordnung nach dem Stand der Technik, im Querschnitt,

Fig. 2 ein Diagramm aus dem bezüglich der in Fig. 1 dargestellten Anordnung nach dem Stande der Technik jeweils die Tiefen des PN-Überganges, der Verarmungszonen und der Feldbedingungen ersichtlich sind,

Fig. 3 in Draufsicht die Oberfläche der in den Ansprüchen gekennzeichnet Photodiodenanordnung.

Fig. 4 die in Fig. 3 dargestellte Photodiodenanordnung, im Querschnitt entlang der Linie 4...4,

Fig. 5 ein Diagramm, aus dem bezüglich der in Fig. 4 dargestellten Anordnung jeweils die Tiefen des PN-Überganges, der Verarmungszonen und der Feldbedingungen ersichtlich sind, und

Fig. 6 eine Reihe von Photodiodenanordnungen, die einen Teil einer linearen Abtasteinrichtung bilden.

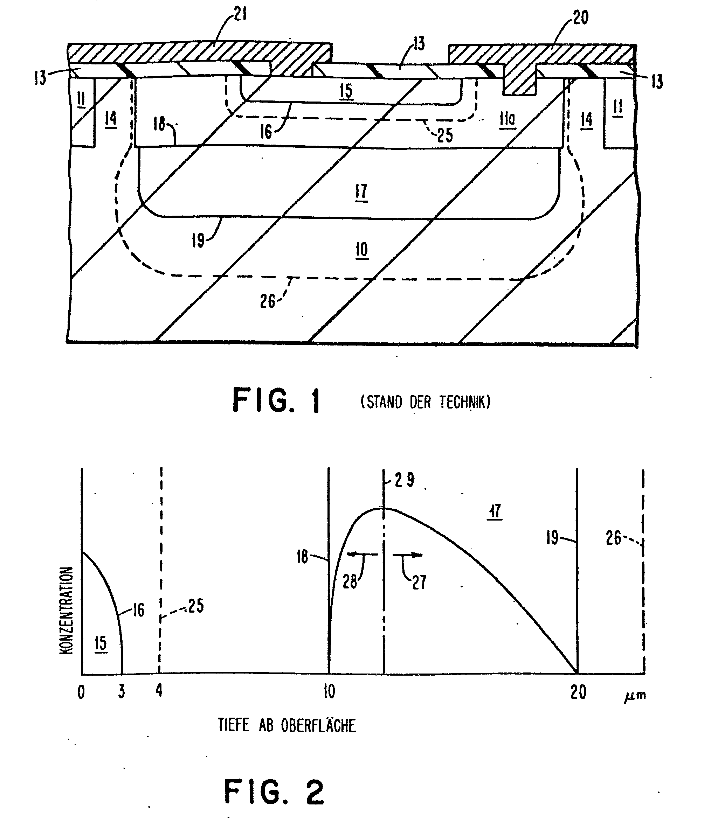

In Fig. 1 ist im Querschnitt eine typische Photodiodenanordnung bekannter Art dargestellt. Diese Anordnung besteht aus einem Substrat 10 aus P-leitendem Material mit einem spezifischen Widerstand von ungefähr 3 Ohm × cm, auf welchem eine Epitaxieschicht 11 aus N-leitendem Silicium aufgebracht ist. Die Epitaxieschicht 11 hat einen inselartigen Bereich 11a, der von der Schicht 11 durch einen ringförmigen, P-leitenden Isolationskanal 14 getrennt ist. Der Isolationskanal 14 erstreckt sich von der Oberfläche der Anordnung durch die Epitaxieschicht und vereinigt sich mit dem Substrat 10. Angrenzend an die Oberfläche und innerhalb des inselartigen Bereichs 11a der Epitaxieschicht ist eine diffundierte, $3\,\mu m$ tiefe P-leitende Zone vorhanden. Die P-leitende Zone 15 bildet mit der Epitaxieschicht einen PN-Übergang 16. Unter der Zone 15 liegt eine vergrabene N+-leitende Subkollektor-Schicht 17, die mit der Epitaxie schicht 11 eine Grenzfläche 18 bildet. Zwischen dem Subkollektor 17 und dem Substrat 10 wird ein zweiter PN-Übergang 19 gebildet. Dieser Übergang 19 vereinigt sich mit dem Übergang zwischen dem P+-Isolationskanal 14 und der Epitaxieschicht 11a. Diese bekannte Anordnung weist somit zwei separate, bestimmte und nicht zusammenhängende PN-Übergänge 16 und 19 auf.

Die Strahlung des sichtbaren Lichts liegt im allgemeinen im Bereich von 400 nm bis 800 nm. die Absorptionslänge der Strahlung mit der größten Eindringtiefe und der größten Wellenlänge (800 nm) beträgt ungefähr zehn um.

Da bei der bekannten Anordnung sichergestellt werden sollte, daß keine Ladungsträger unterhalb der nach oben gerichteten Driftfelder, die in der Nähe der Grenzfläche 18 existieren, erzeugt wurden, wurde die Grenzfläche 18 ungefähr zehn um unterhalb der Oberfläche der Anordnung gelegt. Der vertikale Abstand des PN-Überganges 16 wurde so bemessen, daß zwischen ihm und der Grenzfläche 18 ein Abstand von 7 $\mu$m eingehalten wurde. Um sicherzustellen, daß keiner der in der Anordnung erzeugten Minoritätsladungsträger bis zum PN-Übergang 19 vordringt, wurde ferner der Subkollektor 17 mit einer Dicke von zehn $\mu$m in das Substrat hinein ausgebildet, einen Wert der größer ist als zwei Diffusionslängen der Minoritätsträger (in diesem Falle Löcher), die durch Absorption von Licht im Subkollektor erzeugt werden.

Auf der Oberfläche der Anordnung ist eine Oxidschicht 13 aufgebracht mit Öffnungen, durch welche Kontakte mit dem inselartigen Bereich 11a und der diffundierten Zone 15 hergestellt werden.

Uber der Oxidschicht 13 befindet sich eine leitende Schicht 20, die den Kontakt mit dem N-leitenden Epitaxiebereich 11a herstellt, und eine weitere leitende Schicht 21, die den diffundierten Bereich 15 kontaktiert. Um unerwünschte Photoströme zu vermeiden, die dadurch entstehen, daß Licht auf die Grenzflächen der PN-Übergänge 16 und 19 an der Oberfläche auftrifft, sind die Leiterzüge 20 und 21 undurchsichtig gemacht und so ausgebildet, daß sie im wesentlichen die PN-Übergänge 16 und 19 überall da, wo diese auf die Oberfläche auftreffen, überdecken.

Wenn die Anordnung beispielsweise mit 8 V zwischen den Anschlüssen 20 und 21 vorgespannt wird, bildet sich um den Übergang 15 eine Verarmungszone aus, die sich, wie durch die gestrichelte Linie 25 angedeutet, bis zu einem Abstand von ungefähr 1 $\mu$m in das N-leitende Material 11a erstreckt. Selbstverständlich erstreckt sich der Verarmunsbereich auf beiden Seiten des vorgespannten Überganges 16; er erstreckt sich jedoch als Folge der angelegten Spannung und der Dotierungskonzentration der Zone 15 nur über einen derart kleinen Abstand in die Zone 15, so daß zur Verdeutlichung der Darstellung die Grenze des Verarmungsbereichs in der Zone 15 nicht dargestellt ist. Eine ähnliche Verarmungszone erstreckt sich um den PN-Übergang 19, wenn das Substrat bezüglich der Epitaxieschicht 11a und des Subkollektors 17 vorgespannt wird. Auch hier ist aus Gründen der Klarheit der Darstellung nur die Grenze 26 dieser Verarmungszone eingezeichnet. Da das Substrat nur schwach dotiert ist, liegt diese Grenze 26 tief im Substrat 10.

Besser zu ersehen sind diese Verhältnisse in dem Diagramm der Fig. 2, das sich auf die Dotierungskonzentration in verschiedenen Bereichen und auf andere Charakteristika der Anordnung bezüglich ihrer Tiefe in der Anordnung bezieht.

Von besonderem Interesse in diesem Diagramm sind die Driftfelder, die im Subkollektor 17 existieren. Diese Driftfelder sind eine Folge der Konzentration des Subkollektors bezüglich der angrenzenden Bereiche, dem Epitaxiebereich 11a und dem Substrat 10. Diese Driftfelder erstrecken sich, wie durch die Pfeile 28 und 27 angedeutet, in beide Richtungen, wobei die Stelle der größten Konzentration im Subkollektor 17 durch die Linie 29 angedeutet ist. Bei den bekannten Anordnungen wurde der Subkollektor tief in das Substrat vergraben, um mit Hilfe des durch den Pfeil 28 angedeuteten obersten Driftfeldes die Minoritätsladungsträger, die zwischen dem PN-Übergang 16 und der Grenzfläche 18 gebildet wurden, gegen den PN-Übergang 16 zu treiben. Dadurch wurde der Strom über den PN-Übergang 19 reduziert, der als verloren und als parasitärer Leckstrom angesehen wurde. Alle Minoritätsladungsträger, die unterhalb der Stelle der höchsten Konzentration im Subkollektor 17 gebildet werden, werden in Richtung des Pfeiles 27 durch das untere Driftfeld über den Übergang 19 getrieben. Diese Ladungsträger werden sodann im Substrat absorbiert und tragen nicht zu dem in der Anordnung erzeugten Strom bei.

Bei den bekannten Anordnungen wird der Subkollektor so tief in das Substrat vergraben, so daß der entstandene PN-Übergang 19 so tief liegt, daß wenig oder keine Strahlung bis zu ihm vordringt und wenig Minoritätsladungsträger zu ihm hinunterdiffundieren.

Die Intensität eines monochromatischen Lichtstrahls, der ein absorbierendes Medium durchdringt, nimmt nach dem klassischen Beer'schen Gesetz ab, das vom anfänglichen Fluß an der Oberfläche des Mediums, dem Abstand, bis zu welchem der Lichtfluß in das Medium vorgedrungen ist, dem Medium selbst und dem Absorptionskoefizient des Mediums abhängt. In einer lichtempfindlichen Siliciumdiode wird, wenn die Photonenergie, d.h. die Wellenlänge die absorbierten Lichts, größer ist als der Bandabstand im Silicium, aus jedem absorbierten Photon ein Loch-Elektron-Paar erzeugt. In jeder Verarumungszone, die den PN-Über-

gang in solchen Halbleiterdioden umgibt, entsteht aus jedem Loch-Elektron-Paar ein einziger Ladungsträger, während in den übrigen Bereichen nur die Minoritätsladungsträger aus dem Loch-Elektron-Paar zum externen Strom beitragen. Das Verhältnis der Anzahl der erzeugten Loch-Elektron-Paare zu der Anzahl der Minoritätladungsträger, die den Strom sammelnden PN-Übergang überqueren, definiert die Quantenwirksamkeit der Anordnung. Der Wirkungsgrad der Anordnung, der definiert ist als das Verhältnis der Stromdichte am Ausgang zum einfallenden Lichtstrom, ist linear abhängig von der Wellenlänge des einfallenden Lichts und exponentiell von der Tiefe des Subkollektors. Die Tiefe des Subkollektors stellt somit eine fundamentale Begrenzung für den aus dem Maximum der verfügbaren Photonen erzeugten Strom in einer solchen Anordnung dar. Somit sind im wesentlichen drei Bereiche des Halbleitersubstrats, die geprüft werden müssen:

(1) die diffundierte, P-leitende Oberflächenzone,

(2) die zwischen der Verarumungszone und der Grenzfläche des Subkollektors mit der Epitaxieschicht liegende Zone, und

(3) der Subkollektor selbst.

Jede dieser Zonen muß in Betracht gezogen werden. Die P-leitende Oberflächenzone 15 und der benachbarte Raumladungs bzw. Verarmungsbereich sind am einfachsten zu erledigen, da alle Loch-Elektron-Paare, die in diesem Bereich erzeugt werden, unmittelbar abwandern und durch die Felder in diesem Bereich über den PN-Übergang 16 getrieben werden und damit zum Strom beitragen. Die unterhalb der Grenze 25 der Verarmungszone, jedoch oberhalb der Grenzfläche 18 erzeugten Loch-Elektron-Paare wandern langsam durch einen Diffusionsmechanismus zum Übergang 16.

Da die Minoritätsträger (Löcher) eine Diffusionslänge in dem angegebenen Material von ungefähr 4 $\mu$m besitzen und da die Zone zwischen der Grenze 25 des Verarmungsgebietes und der Grenzfläche 18 ungefähr 6 $\mu$m dick ist, tritt für die Minoritätsträger bei ihrer Diffusion durch diese Zone eine beträchtliche Rekombination auf. Durch die Rekombination wird die Quantenwirksamkeit der Anordnung reduziert. Diejenigen Ladungsträger, die dicht oder leicht unterhalb der Grenzfläche 18 erzeugt werden, gelangen unter den Einfluß des Driftfeldes, das durch den Pfeil 28 angedeutet ist, und werden zum Übergang 16 getrieben. Durch den Einfluß dieses Driftfeldes 28 können die Minoritätsträger nicht zum übergang 19 diffundieren. Somit wirkt der obere Bereich des Subkollektors als Reflektor für die Minoritätsträger, die oberhalb des Subkollektors erzeugt wurden.

Diejenigen Ladungsträger, die im Subkollektor unterhalb der Stelle der höchsten Konzentration 29 erzeugt werden, gelangen unter den Einfluß des Driftfeldes 27 und werden zum Übergang 19 getrieben. Da jedoch die Ladungsträger, die den Übergang 19 überqueren, nicht gesammelt werden, tragen sie zum Strom nichts bei und gehen im Substrat 10 verloren.

Aus diesen Gründen wird die Quantenwirksamkeit der beschriebenen, bekannten Anordnungen beträchtlich reduziert, wenn die Wellenlänge des einfallenden Lichts ansteigt. Bei 500 nm beträgt die Quantenwirksamkeit einer solchen bekannten Anordnung nur 80%, bei 630 nm fällt sie auf 62%, bei 800 nm ist sie weiter reduziert auf 29%, und bei 900 nm fällt sie auf einen Wert von nur 14% ab.

Der Stand der Technik lehrt somit, daß es notwendig ist, die Grenzfläche zwischen der Epitaxieschicht und dem Subkollektor ungefähr zehn $\mu$m von der Oberfläche entfernt anzuordnen und den Übergang 19 zwischem Subkollektor und dem Substrat ungefähr 20 $\mu$m von der Oberfläche anzuordnen, um zu verhindern, daß in der Nähe des Subkollektor/Substrat-PN-Übergangs 19 Ladungsträger erzeugt werden und um zu verhindern, daß Minoritätsträger über den PN-Übergang 19 im Substrat verschwinden und somit nicht vom lichtempfindlichen PN-Übergang 16 gesammelt werden. Jeglicher Stromfluß über den Übergang 19 wird vom Stand der Technik als Leckstrom und damit als vorloren angesehen.

Die in den Ansprüchen gekennzeichnete Anordnung lehrt demgegenüber, daß keiner dieser Ströme verloren sein muß und daß alle erzeugten Ladungsträger zum Photostrom beitragen können. Damit wird die Quantenwirksamkeit der Anordnung wesentlich erhöht und beträgt annähernd 100%.

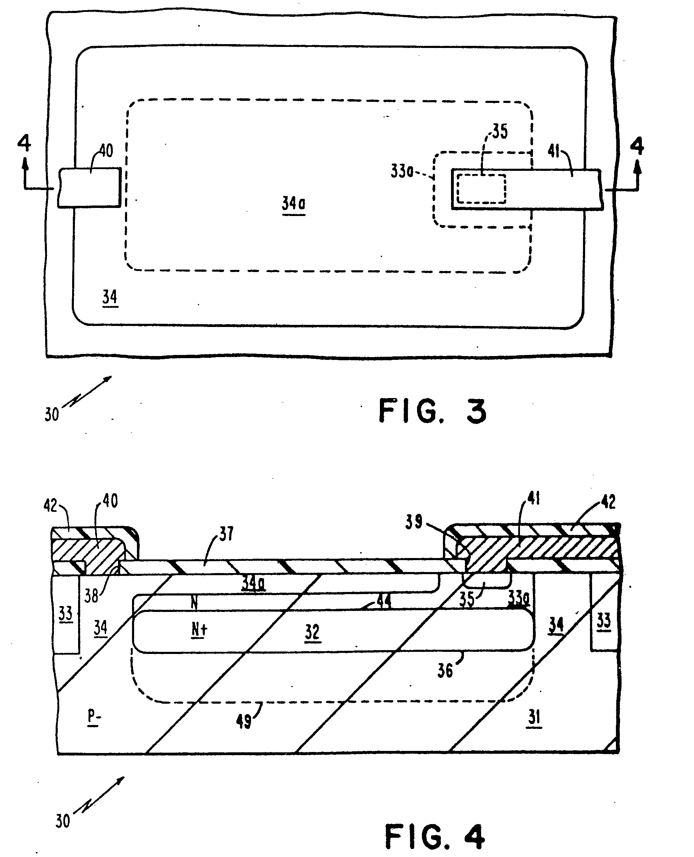

Die Anordnung, mit der dieses erreicht wird, ist in den Fign. 3 und 4 dargestellt. Die in diesen Figuren mit 30 bezeichnete Photodiodenanordnung, auch Photodetektorzelle genannt, erreicht eine Quantenwirksamkeit von nahezu 100% über den gesamten Bereich des sichtbaren Lichts von 400 nm bis 900 nm.

Die Anordnung enthält ein P-leitendes Siliciumhalbleitersubstrat 31 mit einem spezifischen Widerstand von ungeführ 5 Ohm x cm, in welches mit Hilfe der üblichen Technik der integrierten Schaltungen ein N-leitender Subkollektorbereich 32 diffundiert wird. Der Diffusionsprozeß wird solange fortgesetzt, bis der Subkollektorbereich eine Tiefe von ungefähr 3$\mu$m in dem Substrat erreicht. Daraufhin wird auf dem Substrat ein N-leitende Epitaxieschicht 33 mit einem spezifischen Widerstand von ungeführt 0,5 Ohm x cm bei einer Temperatur von ungefähr 1200°C und einer Dicke von nicht mehr als 4$\mu$m aufgewachsen. Während des Wachsens der Epitaxischicht 33 auf der Oberfläche des Substrats 31 dringt der Subkollektorbereich 32 teilweise, d.h. ungefähr 1,4 $\mu$m in die wachsende Epitaxieschicht 33 ein. Nach dem Aufwachsen der Epitaxieschicht 33 in der gewünschten Dicke wird in einem nächsten Prozeßschritt durch bekannte Ver-

fahren, wie Ionenimplantation, Diffusion usw., ein P+-Isolationsring 34 erzeugt, der durch die gesamte Dicke der Epitaxieschicht 33 hindurchdringt und sich mit dem P-leitenden Substrat 31 vereinigt, so daß der Subkollektorbereich 32 vollständig umgeben und isoliert ist. Damit ist eine Schicht des zweiten Leitungstyps in Form einer zentralen taschenartigen Zone 33a der Epitaxieschicht 33 isoliert und bestimmt. Diese zentrale Zone 33a liegt über dem Subkollektorbereich 32. Nach der Herstellung dieses P+-Isolationsringes 34 wird durch Diffusion oder ein anderes Verfahren eine flache P+-leitende Oberflächenschicht 34a mit einer Dicke von ungefähr 0,5 $\mu$m gebildet. Diese Schicht bedeckt im wesentlichen die gesamte Oberfläche der über dem Subkollektor 32 liegenden zentralen Zone 33a der Schicht 33 und vereinigt sich mit dem P+-Isolationsring 34. Damit sind die zentralen Zonen N-leitenden Materials 33a und der Subkollektor 32 nahezu vollständig von einem einzigen, kontinuierlichen PN-Übergang 36 umgeben. Die flache, P+-leitende Oberflächenschicht 34a besitzt eine kleine Öffnung, durch welche ein N+-leitender Bereich 35 diffundiert wird, um die N-leitende zentrale Zone 33a zu kontaktieren. Daraufhin wird die Anordnung mit einer Schicht 37 aus Siliciumdioxid in einer Dicke von ungefähr 800 nm überzogen. Durch diese Schicht 37 werden zwei getrennte Fenster oder Durchgangslöcher 38 und 39 eingebracht. Das Fenster 38 liegt über einem Teil des Isolationsringes 34, und das Fenster 39 liegt über dem N-leitenden, sich zur oberfläche erstreckenden Diffusionsbereich 35. Nach dem Öffnen der Fenster werden leitende Aluminiumleiterzüge 40 und 41 aufgebracht, die jeweils Kontakt mit dem Isolationsring 34 und dem diffundierten, sich zur Oberfläche erstreckenden Bereich 35 herstellen. Über den metallischen Leiterzügen 40 und 41 kann eine Quarzschicht 42 aufgebracht werden. Vorzugsweise wird der Leiterzug 40 so ausgebildet, daß er den gesamten Isolationsring 34 bedeckt, um zu verhindern, daß in den Isolationsring eindringendes Licht eine Querkoppelung zwischen aneinandergrenzenden Anordnungen bewirkt.

Der PN-Übergang 36 wird durch Anlegen einer Spannung von beispielsweise 3 V zwischen den Anschlüssen 40 und 41 vorgespannt. Da der Abstand zwischen der Unterkante der Oberflächenschicht 34a und der Grenzfläche 44, zwischen dem Subkollektor 32 und der zentralen Zone 33a zwischen 0,5 $\mu$m und 1 $\mu$m liegt, ist bei dieser Vorspannung die zentrale Zone 33a zwischen der Oberflächenschicht 34a und dem Subkollektor 32 vollständig verarmt. In diesen Figuren ist daher die Unterkante dieses Verarmungsbereichs nicht dargestellt, da sie im wesentlichen entlang der Linie der Grenzfläche 44 verläuft. Die Vorspannung des PN-Überganges 36 verursacht selbstverständlich eine Verarumungszone, die sich bis zu einem beträchtlichen Abstand in das Substrat erstreckt. Bei der beschriebenen Vorspannung dehnt sich diese Verarmungszone ungefähr 10 $\mu$m in das Substrat 31 hinein aus, so daß die Unterkante dieser Verarmungszone ungefähr 18 $\mu$m von der Oberfläche der Anordnung entfernt ist, wie durch die gestrichelte Linie 49 angedeutet. Wegen der Konzentration des Isolationsringes 34 und der Oberflächenschicht 34a dehnt sich die Verarmungszone nicht weit in diesen Gebieten aus.

Es ist hervorzuheben, daß, im Gegensatz zu den in den Fign. 1 und 2 dargestellten, bekannten Anordnungen, bei der beschriebenen Anordnung die Grenzfläche 36 zwischen dem Subkollektor und dem Substrat weniger als 10 $\mu$m von der Oberfläche entfernt ist. Die Epitaxischicht 33 ist dünn, d.h., weniger als 4 $\mu$m dick. Die Oberflächenschicht 34a ist nicht nur flach, d.h. weniger als 1 $\mu$m dick, sonderen bildet einen PN-Übergang mit dem epitaktischen Material, und dieser PN-Übergang vereinigt sich durch den Isolationsring 34 mit dem PN-Übergang, der zwischen der Oberflächenschicht 34a und der zentralen Zone 33a gebildet ist und bildet somit einen einzigen, kontinuierlichen PN-Übergang 36, der den gesamten, vergrabenen N-leitenden epitaktischen Bereich zentralen Zone 33a und den Subkollektor 32 im wesentlichen umgibt.

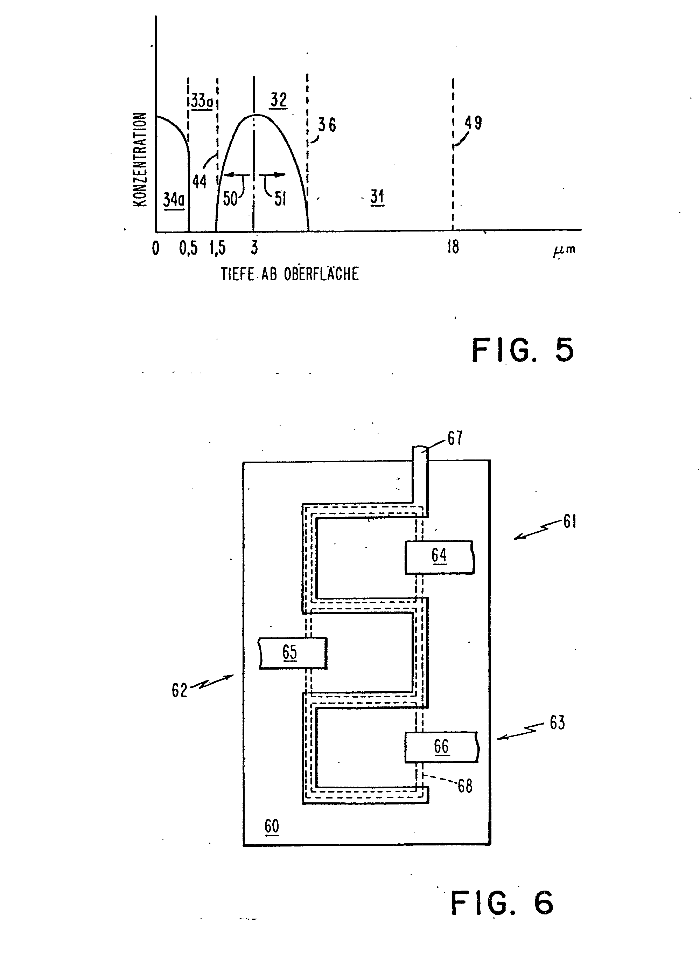

Wenn somit elektromagnetische Strahlung im Bereich von 400 nm bis 900 nm auf die innerhalb des Isolationsringes 34 definiert Zone auftrifft, wird er absorbiert, und im Halbleitermaterial werden Loch-Elektron-Paare gebildet. Wenn diese Paare im Bereich 34a oder in der vollständig verarmten Zone 33a erzeugt werden, werden die Minoritätsträger unmittelbar über den PN-Übergang zwischen dem Bereich 34a und dem Bereich 33a getrieben. Diejenigen Paare, die im oberen Teil des Subkollektors 32 gebildet werden, gelangen unter den Einfluß des Driftfeldes, das durch den Pfeil 50 (Fig. 5) angedeutet ist, und der Minoritätsträger des Paares wird nach oben getrieben zu demjenigen Teil des PN-Überganges 36, der zwischen dem diffundierten Bereich 34a und dem epitakischen Bereich 33a liegt.

Diejenigen Paare, die in der unteren Hälfte des Subkollektors erzeugt werden, gelangen unter den Einfluß des Driftfeldes das durch den Pfeil 51 (Fig. 5) angedeutet ist, und die Minoritätsträger werden gegen denjenigen Teil des PN-Überganges 36 getrieben, der zwischen dem Subkollektor 32 und dem Substrat 31 liegt. Diejenigen Paare, die im Verarmungsbereichs unterhalb des Subkollektors entstehen, werden ebenfalls zu diesem Teil des PN-Überganges 36 getrieben.

Da derjenige Teil des Überganges 36, der zwischen dem Subkollektor 32 und dem Substrat 31 liegt, ungefähr 8 $\mu$m tief angeordnet ist und da die untere Verarmungszone sich etwa 18 $\mu$m unterhalb der Oberfläche der Anordnung erstreckt, wird alles Licht im interessierenden Wellenlängenbereich, d.h. zwischen 400 nm und 900 nm innerhalb von 15 $\mu$m absorbiert.

Alle in der Anordnung erzeugten Minoritätsträger gelangen unmittelbar unter den Einfluß entweder eines Driftfeldes oder einer Verarmungszone und werden auf diese Weise schnell über den sammelnden Übergang 36 gezwungen. Die Anordnung spricht daher sehr schnell an. Da ferner keine Gebiete vorhanden sind, durch welche die Minoritätsträger durch einen Diffusionsmechanismus wandern, kann praktisch keine Rekombination stattfinden, und damit ist eine im wesentlichen 100%ige Quantenwirksamkeit erreicht.

Da die Anordnung nur einen einzigen PN-Übergang 36 aufweist, werden alle Minoritätsträger, die erzeugt wurden, über diesen Übergang getrieben und gesammelt.

In Fig. 6 sind in einem einzigen Substrat 60 drei Diodenanordnungen 61, 62, 63 untergebracht. Drei getrennte Leitungsanschlüsse 64, 65 und 66 (entsprechend dem Anschluß 41 in Fig. 3) sind jeweils für die vergrabenen Epitaxieschichten angeordnet, während ein einziger, mäanderförmiger Leiterzug 67 im wesentlichen über allen Isolationskanälen zwischen den Diodenanordnungen liegt. Der Isolationskanal besteht aus einer fortlaufenden, leiterähnlichn Konfiguration 68, wie durch gestrichelte Linien dargestellt. Zur Verdeutlichung ist nur der Isolationskanal dargestellt, der die Dioden-anordnungen von den benachbarten Dio-enanordnungen trennt. Es versteht sich, daß jede dieser Anordnungen identisch mit den in den Fign. 3 und 4 dargestellten Anordnungen ist. Der Leiterzug 67 dient nicht nur zur Herstellung des elektrischen Kontaktes mit den Isolationskanälen, sondern auch zur Abdeckung des Kanals zwischen den Diodenanordnungen, um eine wilde Kopplung zwischen benachbarten Diodenanordnungen zu vermeiden.

**Patentansprüche**

1. Photodiodenanordnung, bei welcher auf einem Halbleitersubstrat (31) eines ersten Leitungstyps eine von einem Isolationsring (34) desselben Leitungstyps umgebene Schicht (33a) eines zweiten Leitungstyps mit einem darunterliegenden, höher dotierten, als Subkollektor (32) dienenden Bereich, und innerhalb dieser Schicht, angrenzend an dei Oberfläche der Anordnung, eine dünne Oberflächenschicht (34a) des ersten Leitungstyps gebildet sind und die Oberflächenschicht (34a) sowie die Schicht (33a) des zweiten Leitungstyps jeweils einen an der Oberfläche liegenden Kontaktanschluß (40, 41) aufweisen, dadurch gekennzeichnet, daß die Oberflächenschicht (34a) des ersten Leitungstyps mit dem Isolationsring (34) verbunden ist, derart, daß die Grenzflächen zwischen der Oberflächenschicht (34a) und der Schicht des zweiten Leitungstyps (33a) sowie zwischen dem Subkollektor (32) der Schicht des zweiten Leitungstyps (33a) und dem Substrat (31) einen einzigen, kontinuierlichen pn-Übergang bilden, und daß die unterhalb der Oberflächenschicht (34a) entstehende Verarmungszone sich bei Vorspannung der Diode in Sperrichtung vollständig über die Schicht (33a) des zweiten Leitungstyps bis an die Oberfläche (44) des Subkollektors (32) erstreckt.

2. Anordnung nach Anspruch 1, dadurch gekennzeichnet, daß die Schicht des zweiten Leitungstyps (33) weniger als 4 $\mu$m dick ist.

3. Anordnung nach den Ansprüchen 1 und 2, dadurch gekennzeichnet, daß dei Oberflächenschicht (34a) des ersten Leitungstyps weniger als 1 $\mu$m dick ist.

4. Anordnung nach den Ansprüchen 1 bis 3, dadurch gekennzeichnet, daß derjenige Teil des pn-Überganges, der sich zwischen dem Subkollektor (32) und dem Substrat (31) erstreckt, weniger als 10 $\mu$m von der Oberfläche ent-fernt ist.

5. Anordnung nach den Ansprüchen 1 bis 4, dadurch gekennzeichnet, daß die Kontakte (40, 41) im Bereich des Isolierringes (34) und in einem sich zur Oberfläche erstreckenden Bereich (35) der Schicht des zweiten Leitungstyps angeordnet sind, und daß die Oberfläche der Anordnung in den Bereichen der Kontakt (40, 41) mit einer Schicht (42) aus undurchsichtigem Material abgedeckt ist.

6. Anordnung nach den Ansprüchen 1 bis 5, dadurch gekennzeichnet, daß der zwischen dem Subkollektor (32) und dem Substrat (31) gebildete Teil des pn-Über-ganges (36) etwa 8 $\mu$m von der Oberfläche ent-fernt angeordnet ist und sich seine Verarmungs-zone bis etwa 18 $\mu$m unterhalb der Oberfläche erstreckt, derart, daß auf die Anordnung auftreffendes Licht im Wellenlängenbereich von 400 nm bis 900 nm, das bis zu einer Tiefe von 15 $\mu$m von der Oberfläche vollständig absor-biert wird, Ladungsträger im Verarmungs-bereich des pn-Überganges bildet.

**Revendications**

1. Dispositif du genre photodiode dans lequel, sur un substrat semi-conducteur (31) d'un premier type de conductivité, est disposée une couche (33a) d'un second type de conductivité entourée d'un anneau d'isolement (34) dudit premier type de conductivité avec une région sous-jacente à dopage plus élevé servant de sous-collecteur (32), dans cette couche adjacente à la surface du dispositif est déposée une couche mince (34a) de surface du premier type de conductivité, la couche de surface (34a) ainsi que la couche (33a) établissent un contact (40, 41) avec la surface, ce dispositif étant caractérisé en ce que la couche de surface (34a) du premier type de conductivité est connectée avec l'anneau d'isolement (34) de telle sorte que les interfaces entre la couche de surface (34a) et la couche du second type de conductivité (33a) d'une part, entre le sous-collecteur (32) de la couche (33a) du second type de conductivité et le substrat (31) d'autre part, forment une seule jonction pn continue et en ce que la région d'appauvrissement se produisant en dessous de la couche de surface (34a) s'étale complètement à travers la couche (33a) du second type de conductivité jusqu'à la surface (44) du sous-collecteur (32) lorsque la diode est polarisée dans le sens bloqué.

2. Dispositif selon la revendication 1, caractérisé en ce que la couche du second type de conductivité (33) a une épaisseur inférieure à 4 µm.

3. Dispositif selon l'une quelconque des revendications 1 et 2, caractérisé en ce que la couche de surface (34a) du premier type de conductivité a une épaisseur inférieure à 1 µm.

4. Dispositif selon l'une quelconque des revendications 1 à 3, caractérisé en ce que la partie de la jonction pn s'étendant entre le sous-collecteur (32) et le substrat (31) se trouve à une distance inférieure à 10 µm de la surface.

5. Dispositif selon l'une quelconque des revendications 1 à 4, caractérisé en ce que les contacts (40, 41) se trouvent dans la zone de l'anneau d'isolement (34) et dans une région (35) de la couche du second type de conductivité s'étalant jusqu'à la surface, et en ce que la surface du dispositif est recouverte d'une couche (42) d'un matériau opaque dans les régions des contacts (40, 41).

6. Dispositif selon l'une quelconque des revendications 1 à 5, caractérisé en ce que la partie de la jonction pn (36) formée entre le sous-collecteur (32) et le substrat (31) est disposée à une distance d'environ 8 µm de la surface et en ce que sa région d'appauvrissement s'étale jusqu'à environ 18 µm en dessous de la surface de telle sorte que la lumière rencontrant le dispositif dans la gamme des longueurs d'onde de 400 nm à 900 nm qui est complètement absorbée jusqu'à une profondeur de 15 µm à compter de la surface, forme des porteurs de charge dans la région d'appauvrissement de la jonction pn.

**Claims**

1. Photo diode arrangement, wherein on a semiconductor substrate (31) of a first conductivity type a layer (33a) of a second conductivity type is formed surrounded by an isolation ring (34) of the first conductivity type, and a more highly doped region (32) of the second conductivity type serving as subcollector is formed beneath the layer (33a), wherein within the layer (33a), adjacent to the arrangement surface, a thin surface layer (34a) of the first conductivity type is formed, and wherein the surface layer (34a) and the layer (33a) of the second conductivity type each have respective conductive line (40, 41) on the arrangement surface, characterized in that the surface layer (34a) of the first conductivity type is connected to the isolation ring (34) in such a manner that the interfaces between the surface layer (34a) and the layer of the second conductivity type (33a), and between the subcollector (32) of the layer of the second conductivity type (33a) and the substrate (31) form one single continuous pn junction, and in that when the diode is reverse biased the depletion zone formed under the surface layer (34a) extends completely through the layer (33a) of the second conductivity type to the surface (44) of the subcollector (32).

2. Arrangement as claimed in claim 1, characterized in that the layer of the second conductivity type (33) is less than 4 µm thick.

3. Arrangement as claimed in claims 1 and 2, characterized in that the surface layer (34a) of the first conductivity type is less than 1 µm thick.

4. Arrangement as claimed in claims 1 to 3, characterized in that the part of the pn junction extending between the subcollector (32) and the substrate (31) is less than 10 µm from the surface.

5. Arrangement as claimed in claims 1 to 4, characterized in that the contacts (40, 41) are arranged in the region of the isolation ring (34) and in a region (35) of the layer of the second conductivity type, said latter region extending to the surface, and in that the surface of the arrangement is covered in the region of the contacts (40, 41) with a layer (42) of opaque material.

6. Arrangement as claimed in claims 1 to 5, characterized in that the part of the pn junction (36) formed between the subcollector (32) and the substrate (31) is arranged at a distance of approximately 8 µm from the surface and extends in its depletion zone down to approximately 18 µm beneath the surface, in such a manner that light incident on the arrangement in a wavelength range of 400 nm to 900 nm which is fully absorbed down to the depth of 15 µm from the surface, forms carriers in the depletion zone of the pn junction.

FIG. 1 (STAND DER TECHNIK)

FIG. 2

FIG. 3

FIG. 4

**0 002 752**

FIG. 5

FIG. 6